# EUROPEAN PATENT APPLICATION

(11) **EP 2 114 016 A2**
(43) Date of publication of application: **04.11.2009**
(21) Application number: 09005425.5
(22) Date of filing: 16.04.2009
(51) Int. Cl.: H04B 1/38, H04B 1/04

(54) **Method and system for flip-chip RF front end with switchable power amplifier**

(30) Priority: 30.04.2008 US 112252
(71) Applicant: Broadcom Corporation, Irvine, CA 92617 (US)
(72) Inventor: Roufoogaran, Razieh, Venice, CA 90291 (US)
(74) Representative: Jehle, Volker Armin

(57) **Abstract**

Methods and systems for a flip-chip RF front end with switchable power amplifier. Aspects of one method may include controlling at least one MEMS switch to allow an on-chip PA and/or an off-chip PA to amplify RF signals for transmission. The MEMS switch may be part of a device package that may be mounted above the flip-chip bonded integrated circuit (IC). Accordingly, various embodiments of the invention may enable controlling of switches to amplify the RF signals via the on-chip RF PA, and the off-chip PA may be bypassed if there is an off-chip RF PA. Various embodiments of the invention may enable controlling the switches to amplify the RF signals via an off-chip RF PA and bypassing an on-chip RF PA. Various embodiments of the invention may also enable controlling the switches to amplify the RF signals via an off-chip RF PA and an on-chip RF PA.

## Description

### CROSS-REFERENCE TO RELATED APPLICATIONS/INCORPORATION BY REFERENCE

[Not Applicable]

### FEDERALLY SPONSORED RESEARCH OR DEVELOPMENT

[Not Applicable]

### [MICROFICHE/COPYRIGHT REFERENCE]

[Not Applicable]

### FIELD OF THE INVENTION

Certain embodiments of the invention relate to wireless communication. More specifically, certain embodiments of the invention relate to a method and system for a flip-chip RF front end with a switchable power amplifier.

### BACKGROUND OF THE INVENTION

In some conventional systems, a wireless system may broadcast radio frequency (RF) signals and receive RF signals. Generally, RF signals are transmitted at power levels that may be specified by various communication standards. For example, a 3G cellular system may use some form of CDMA standard that controls transmission power level of each mobile terminal. Other wireless standards, such as the Bluetooth standard, may allow transmission at different power levels depending on a specification for the range of the Bluetooth device.

The RF signals to be transmitted may be amplified to a desired power level by a power amplifier before being communicated to a transmit antenna. Accordingly, a RF power amplifier may need to be able to output various ranges of power levels. Additionally, a wireless system may also receive RF signals, which may be much weaker than transmitted RF signals. The received RF signals may be amplified to levels suitable for processing by a low noise amplifier (LNA).

Further limitations and disadvantages of conventional and traditional approaches will become apparent to one of skill in the art, through comparison of such systems with some aspects of the present invention as set forth in the remainder of the present application with reference to the drawings.

### BRIEF SUMMARY OF THE INVENTION

A system and/or method for a flip-chip RF front end with a switchable power amplifier, substantially as shown in and/or described in connection with at least one of the figures, as set forth more completely in the claims.
According to an aspect, a method for processing signals is provided, the method comprising:
controlling at least one switch on a device package, wherein said at least one switch enables RF signals to bypass one or more of a plurality of RF power amplifiers and/or be amplified by others of said plurality of power amplifiers, and wherein said device package is mounted above a flip-chip bonded integrated circuit.
Advantageously, said at least one switch is fabricated on said device package using micro electro-mechanical system (MEMS) technology.
Advantageously, the method further comprises amplifying said RF signals via an on-chip RF power amplifier that is part of said flip-chip bonded integrated circuit.
Advantageously, the method further comprises, if there is an off-chip RF power amplifier, enabling said RF signals to bypass said off-chip power amplifier.
Advantageously, the method further comprises amplifying said RF signals via an off-chip RF power amplifier.
Advantageously, the method further comprises enabling said RF signals to bypass an on-chip RF power amplifier that is part of said flip-chip bonded integrated circuit.
Advantageously, the method further comprises amplifying said RF signals via an on-chip RF power amplifier that is part of said flip-chip bonded integrated circuit and via an off-chip RF power amplifier.
Advantageously, the method further comprises configuring said flip-chip bonded integrated circuit and/or said device package for reception of RF signals and/or transmission of RF signals.
Advantageously, the method further comprises configuring said flip-chip bonded integrated circuit and/or said device package for single-ended RF input mode of operation and/or single-ended RF output mode of operation.
Advantageously, the method further comprises configuring said flip-chip bonded integrated circuit and said device package for differential RF input mode of operation and/or differential RF output mode of operation.
Advantageously, said device package comprises a plurality of layers.
Advantageously, at least one of said plurality of layers of said device package comprises a magnetic layer.
According to an aspect, a system for processing signals comprises:
one or more circuits that enable controlling of at least one switch on a device package, wherein said at least one switch enables RF signals to bypass one or more of a plurality of RF power amplifiers and/or be amplified by others of said plurality of power amplifiers, and wherein said device package is mounted above a flip-chip bonded integrated circuit.
Advantageously, said at least one switch is fabricated on said device package using micro electro-mechanical system (MEMS) technology.
Advantageously, said plurality of RF power amplifiers comprise an on-chip RF power amplifier that enables amplification of said RF signals.
Advantageously, said on-chip RF power amplifier is part of said flip-chip bonded integrated circuit.
Advantageously, if there is an off-chip RF power amplifier, said off-chip power amplifier is bypassed.
Advantageously, said plurality of RF power amplifiers comprise an off-chip RF power amplifier, and said one or more circuits enable controlling of said at least one switch for amplification of said RF signals by said off-chip RF power amplifier.
Advantageously, said one or more circuits enable controlling of at least one switch to enable said RF signals to bypass said on-chip RF power amplifier.
Advantageously, said one or more circuits enable controlling of said at least one switch for amplification of said RF signals by said on-chip RF power amplifier.
Advantageously, the system further comprises configuring said flip-chip bonded integrated circuit and/or said device package for reception of RF signals and/or transmission of RF signals.
Advantageously, the system further comprises configuring said flip-chip bonded integrated circuit and/or said device package for single-ended RF input mode of operation and/or single-ended RF output mode of operation.
Advantageously, the system further comprises configuring at least one of: said flip-chip bonded integrated circuit and said device package for differential RF input mode of operation and/or differential RF output mode of operation.
Advantageously, said device package comprises a plurality of layers.
Advantageously, at least one of said plurality of layers of said device package comprises a magnetic layer.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1A is a block diagram of an exemplary wireless system, which may be utilized in connection with an embodiment of the invention.

FIG. 1B is a block diagram of a device package and a flip-chip, in accordance with an embodiment of the invention.

FIG. 1C is a block diagram of a device package mounted above a flip-chip, in accordance with an embodiment of the invention.

FIG. 1D is a block diagram illustrating an exemplary MEMS switch, in accordance with an embodiment of the invention.

FIG. 2A is a block diagram illustrating an exemplary transceiver and device package, in accordance with an embodiment of the invention.

FIG. 2B is an exemplary block diagram that illustrates using an off-chip power amplifier, in accordance with an embodiment of the invention.

FIG. 2C is an exemplary block diagram that illustrates bypassing an off-chip power amplifier, in accordance with an embodiment of the invention.

FIG. 2D is an exemplary block diagram that illustrates using an on-chip power amplifier, in accordance with an embodiment of the invention.

FIG. 2E is an exemplary block diagram that illustrates bypassing an on-chip power amplifier, in accordance with an embodiment of the invention.

FIG. 3A is a block diagram illustrating an exemplary configuration of a transceiver on a chip, in accordance with an embodiment of the invention.

FIG. 3B is a block diagram illustrating an exemplary configuration of a transceiver on a chip, in accordance with an embodiment of the invention.

FIG. 4 is a block diagram illustrating an exemplary configuration of a transceiver on a chip, in accordance with an embodiment of the invention.

FIG. 5 is a block diagram illustrating an exemplary configuration of a transceiver on a chip, in accordance with an embodiment of the invention.

FIG. 6 is a block diagram illustrating an exemplary configuration of a transceiver on a chip, in accordance with an embodiment of the invention.

FIG. 7 is a flow diagram illustrating exemplary steps for using a flip-chip RF front end with switchable power amplifier, in accordance with an embodiment of the invention.

### DETAILED DESCRIPTION OF THE INVENTION

Certain embodiments of the invention may be found in a method and system for a flip-chip RF front end with a switchable power amplifier. Aspects of the invention may comprise controlling at least one switch on a device package, where a switch may be used to allow RF signals to bypass a RF power amplifier (PA). The RF PA may be an on-chip PA that may be part of a flip-chip bonded integrated circuit. Another RF PA may be an off-chip PA that may not be part of the flip-chip bonded integrated circuit, nor a part of the device package. If the RF power amplifier is not bypassed, the RF power amplifier may provide amplification to the RF signals. The device package may comprise one or more layers that may comprise discrete devices such as, for example, switches, and may be mounted above the flip-chip bonded integrated circuit. The switches may be fabricated on the device package using micro electro-mechanical system (MEMS) technology.

Accordingly, various embodiments of the invention may enable controlling one or more switches to amplify the RF signals via the on-chip RF PA, and the off-chip PA may be bypassed if there is an off-chip RF PA. Various embodiments of the invention may enable controlling one or more switches to amplify the RF signals via an off-chip RF PA and bypassing an on-chip RF PA. Various embodiments of the invention may also enable controlling one or more switches to amplify the RF signals via an off-chip RF PA and an on-chip RF PA. Various discrete devices, such as, for example, switches, capacitors, and/or inductors, on the device package may be configured for RF transmission and/or reception, as needed. The device may also be configured for single-ended RF input, single-ended RF output, differential RF input, and/or differential RF output.

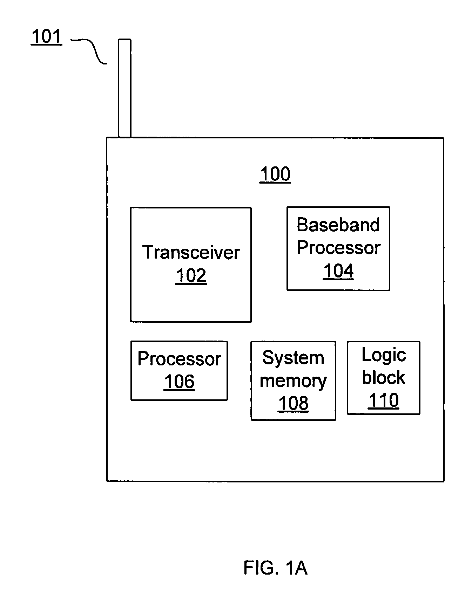

FIG. 1A is a block diagram of an exemplary wireless system, which may be utilized in connection with an embodiment of the invention. Referring to FIG. 1A, the wireless system 100 may comprise an antenna 101, a transceiver 102, a baseband processor 104, a processor 106, a system memory 108, and a logic block 110. The antenna 101 may be used for reception and/or transmission of RF signals. The transceiver 102 may comprise suitable logic, circuitry, and/or code that may be adapted to modulate and upconvert baseband signals to RF signals for transmission by one or more antennas, which may be represented generically by the antenna 101.

The transceiver 102 may also be adapted to downconvert and demodulate received RF signals to baseband signals. The RF signals may be received by one or more antennas, which may be represented generically by the antenna 101. Different wireless systems may use different antennas for transmission and reception. The transceiver 102 may be adapted to execute other functions, for example, filtering the baseband and/or RF signals, and/or amplifying the baseband and/or RF signals.

The baseband processor 104 may comprise suitable logic, circuitry, and/or code that may be adapted to process baseband signals for transmission via the transceiver 102 and/or the baseband signals received from the transceiver 102. The processor 106 may be any suitable processor or controller such as a CPU or DSP, or any type of integrated circuit processor. The processor 106 may comprise suitable logic, circuitry, and/or code that may be adapted to control the operations of the transceiver 102 and/or the baseband processor 104. For example, the processor 106 may be utilized to update and/or modify programmable parameters and/or values in a plurality of components, devices, and/or processing elements in the transceiver 102 and/or the baseband processor 104.

Control and/or data information, which may comprise the programmable parameters, may be transferred from other portions of the wireless system 100, which may not be shown, to the processor 106. Similarly, the processor 106 may be adapted to transfer control and/or data information, which may include the programmable parameters, to other portions of the wireless system 100, which may not be shown, which may be part of the wireless system 100.

The processor 106 may utilize the received control and/or data information, which may comprise the programmable parameters, to determine an operating mode of the transceiver 102. For example, the processor 106 may be utilized to select a specific frequency for a local oscillator, a specific gain for a variable gain amplifier, configure the local oscillator and/or configure the variable gain amplifier for operation in accordance with various embodiments of the invention. Moreover, the specific frequency selected and/or parameters needed to calculate the specific frequency, and/or the specific gain value and/or the parameters, which may be utilized to calculate the specific gain, may be stored in the system memory 108 via the processor 106, for example. The information stored in system memory 108 may be transferred to the transceiver 102 from the system memory 108 via the processor 106. The system memory 108 may comprise suitable logic, circuitry, and/or code that may be adapted to store a plurality of control and/or data information, including parameters needed to calculate frequencies and/or gain, and/or the frequency value and/or gain value.

The logic block 110 may comprise suitable logic, circuitry, and/or code that may enable controlling of various functionalities of the wireless system 100. For example, the logic block 110 may comprise one or more state machines that may generate signals to control the transceiver 102 and/or the baseband processor 104. The logic block 110 may also comprise registers that may hold data for controlling, for example, the transceiver 102 and/or the baseband processor 104. The logic block 110 may also generate and/or store status information that may be read by, for example, the processor 106. Amplifier gains and/or filtering characteristics, for example, may be controlled by the logic block 110.

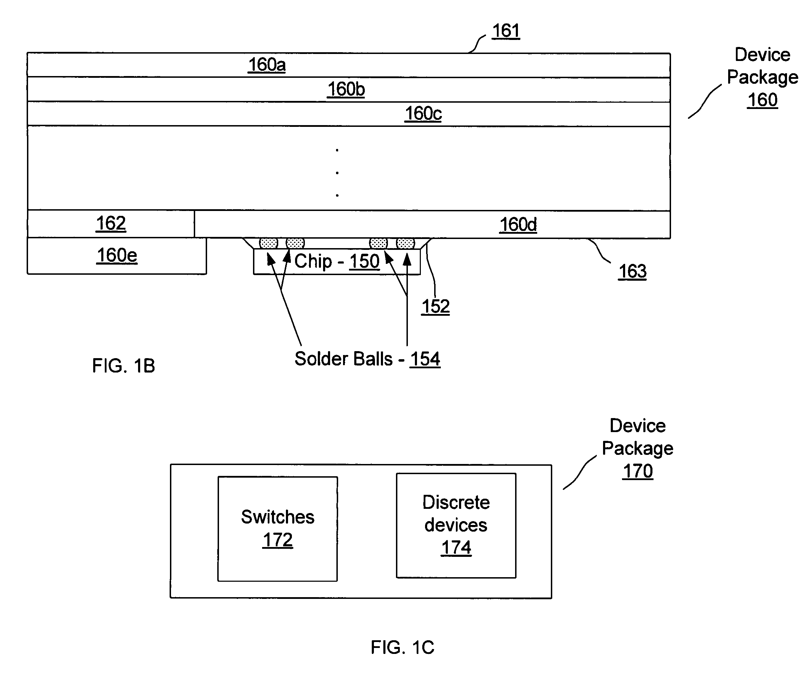

FIG. 1B is a block diagram of a device package and a flip-chip, in accordance with an embodiment of the invention. Referring to FIG. 1B, there is shown an integrated circuit 150, which may comprise, for example, the transceiver 102, which may be bonded, or mounted, as a flip-chip. There is also shown a device package 160 that may comprise, for example, one or more layers 160a ... 160e. Discrete devices (not shown) may be placed on the device package 160, for example, on a surface 161, 163 of the device package 160. The discrete devices may also be embedded in one or more layers of the device package 160. Additionally, various types of devices may be fabricated on the device package 160. For example, trace lines may be used to form inductors and/or resistors. Additionally, a portion of two different layers 160a and 160c of the device package 160 may be used as conductive electrodes, and a portion of a layer 160b may be used as a dielectric. A switch may be fabricated using, for example, MEMS technology.

Conductive paths may be laid on the surface 161, 163 of the device package 160, and also on the plurality of layers 160a ... 160e to communicate electrical signals among the various discrete devices associated with the device package 160. The layer 160e may be directly mounted to a substrate, or a printed circuit board, that the integrated circuit 150 may be mounted to. Conductive paths may also communicate electrical signals from one layer to another in the device package 160, and from the device package 160 to the integrated circuit 150. Distances between conductive paths may be larger than distances between traces on an integrated circuit, such as, for example, the integrated circuit 150. Accordingly, there may be smaller parasitic effects between signals on the conductive paths of the device package 160 than with respect to the same signals on the traces of the integrated circuit 150. Additionally, since the conductive paths of the device package 160 may be wider than the traces on the integrated circuit 150, there may be less signal loss in the device package 160 than in the integrated circuit 150.

The integrated circuit 150 may be bonded to the device package 160 utilizing, for example, the solder balls 154. In this manner, wire bonds connecting the chip 150 to the device package 160 may be eliminated, reducing and/or eliminating uncontrollable stray inductances due to wire bonds. In addition, the thermal conductance out of the chip 150 may be greatly improved utilizing the solder balls 154 and the thermal epoxy 152. The thermal epoxy 152 may be electrically insulating but thermally conductive to allow for thermal energy to be conducted out of the chip 150 to the much larger thermal mass of the device package 160. Materials with magnetic properties may also be deposited on to portions of the layers 160a ... 160e to enhance quality of the discrete devices and/or reduce size of a discrete device. For example, a portion 162 of the layer 160d may be deposited with magnetic material.

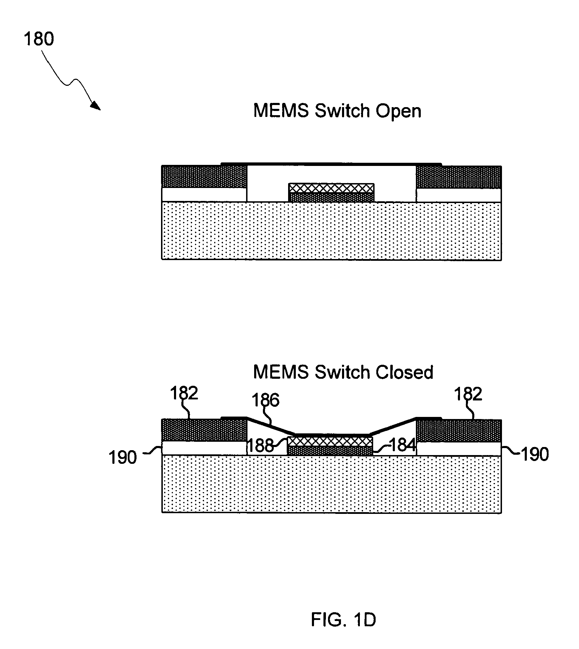

In operation, the integrated circuit 150 may comprise a RF front end, such as, for example, the RF transceiver 102, described with respect to FIG. 1, and may be utilized to transmit and receive RF signals. The integrated circuit 150 may be electrically coupled to the device package 160, where the device package 160 may comprise suitable circuitry that may enable processing signals communicated to or from the integrated circuit 150. Although an embodiment of the invention may be described as comprising the RF transceiver 102, the invention need not be so limited. For example, various embodiments of the invention may comprise separate receivers and transmitters.

FIG. 1C is a block diagram of a device package mounted above a flip-chip, in accordance with an embodiment of the invention. Referring to FIG. 1C, there is shown the device package 170 that may be similar to the device package 160. The device package 170 may comprise one or more switches 172 and one or more discrete devices 174.

The switches 172 may comprise suitable circuitry that may be operable to bypass one or more of a plurality of power amplifiers and/or enable amplification by one or more remaining ones of said plurality of power amplifiers. Some of the power amplifiers may be on-chip while others may be off-chip. The switches 172 may be fabricated, for example, using (micro electro-mechanical system) MEMS technology using one or more layers of the device package 172. An exemplary MEMs switch is described with respect to FIG. 1D. The switches 172 may be controlled, for example, by the baseband processor 104, the processor 106, and/or the logic block 110.

The discrete devices 174 may comprise, for example, capacitors, resistors, balun, and/or inductors that may be used to process the RF signals received and/or transmitted by the integrated circuit 150. The switches 172, and/or other discrete devices 174, may utilize one or more layers of ferromagnetic material in the device package 172. This may result in, for example, increased quality of devices, and/or reducing size of the various devices in the device package 172.

In operation, the switches 172 may be used to bypass a power amplifier during transmission of RF signals. For example, an internal power amplifier may be bypassed in favor of an off-chip power amplifier, or the off-chip power amplifier may be bypassed in favor of the internal power amplifier. Another configuration may not bypass either an internal power amplifier or the off-chip power amplifier. The various discrete devices 174 may be used for AC coupling the RF signals, filtering the RF signals, and/or configuring the wireless system 100 for various types of transmission modes and/or reception modes.

FIG. 1D is a block diagram illustrating an exemplary MEMS switch, in accordance with an embodiment of the invention. Referring to FIG. 1D, there is shown a cross-section view of a MEMS switch 180 in an open position (top) and in a closed position (bottom). The MEMS switch 180 may comprise a metal line in 182, the metal line out 184, the bridge membrane 186, the insulating layer 188 and the electrically isolating layer 190. The insulating layer 188 may be similar to the electrically isolating layer 190.

The metal line in 182 and the metal line out 184 may comprise metal layers deposited on the device package 170. The bridge membrane 186 may comprise a conductive layer that may be supported on each end by the metal line in 182 and may be suspended over the insulating layer 188, when not in a closed position. The insulating layer 188 and the isolating layer 190 may comprise a dielectric layer, such as silicon nitride, for example, that separates the metal line out 184 from the bridge membrane 186 when the MEMS switch 180 may be in the closed position.

In operation, with zero or low DC bias applied between the metal lines 182 and 184, the bridge membrane 186 may be essentially horizontal, such that the MEMS switch 180 may be open (top). In instances where a high enough bias is applied across the metal line out 184 and the metal line in 182, the bridge membrane 186 may be attracted toward the insulating layer 188 by electrostatic force, closing the MEMS switch 180 (bottom).

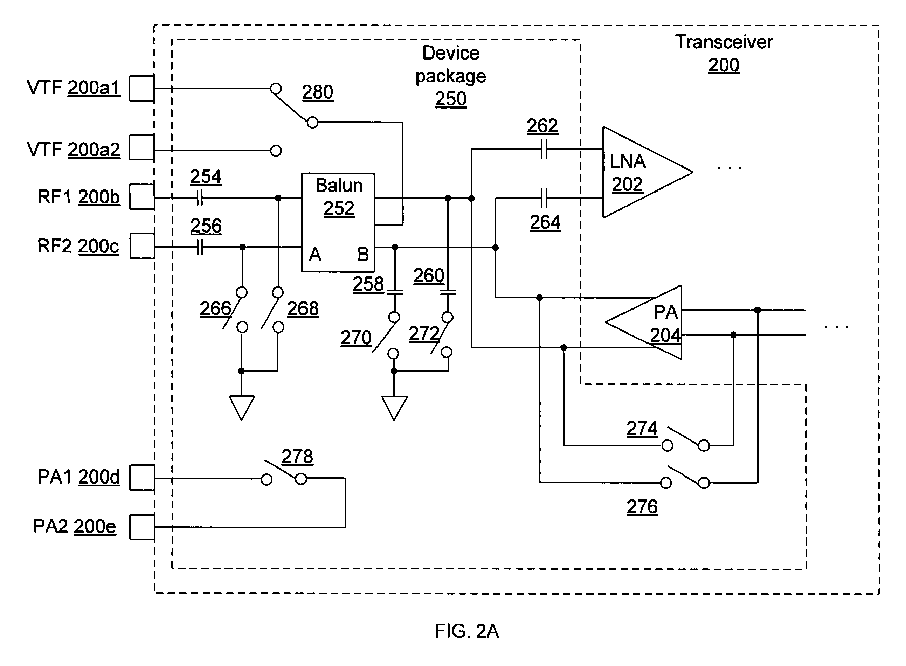

FIG. 2A is a block diagram illustrating an exemplary transceiver and device package, in accordance with an embodiment of the invention. Referring to FIG. 2A, there is shown a transceiver 200, which may be similar in functionality to the transceiver 102. The transceiver 200 may be, for example, on a single chip, such as, for example, the integrated circuit 150. The transceiver 200 may comprise a low-noise amplifier (LNA) 202 and a power amplifier 204. There is also shown a device package 250 that may be similar to the device package 170. The device package 250 may comprise a balun 252, capacitors 254, 256, 258, 260, 262, and 264, and switches 266, 268, 270, 272, 274, 276, 278, and 280. The device package 250 may be placed, for example, above the transceiver 200, as described with respect to FIG. 1B. There are also shown I/O pads 200a1, 200a2, 200b, 200c, 200d, and 200e for input and output of signals. The I/O pads 200a1, 200a2, 200b, 200c, 200d, and/or 200e may be part of the transceiver 200 or the device package 250.

The LNA 202 may comprise suitable logic and/or circuitry that may enable variable gain amplification of RF signals received by, for example, the wireless system 100. The LNA 202 may comprise a single-ended input or differential inputs, and may generate a single-ended output or differential output. The number of inputs and the number of outputs for the LNA 202 may be design and/or implementation dependent. The LNA 202 may be controlled by, for example, the baseband processor 104, the processor 106, and/or the logic block 110.

The power amplifier 204 may comprise suitable logic and/or circuitry that may allow amplification of RF signals for transmission by the wireless system 100. The power amplifier 204 may be, for example, a variable gain amplifier where the output power may be grouped into a plurality of power ranges. For example, one power range may have an upper limit of 5 dBm, and another power range may have an upper limit of 12 dBm. The power amplifier 204 may comprise a single-ended input or differential inputs, and may generate a single-ended output or differential output. The number of inputs and the number of outputs for the power amplifier 204 may be design and/or implementation dependent. The balun 252 may comprise suitable circuitry that may enable coupling RF signals from side A to side B of the balun 252, and vice versa.

The capacitors 254 and 256, and 262 and 264 may provide AC coupling for signals to and from side A of the balun 252, and to the LNA 202, respectively. The switches 266 and 268 may be controlled by a processor in the wireless system 100, such as, for example, the processor 106, to allow different transmission and/or reception configurations. The switches 266 and 268 may also be controlled, for example, by the baseband processor 104 and/or the logic block 110.

The switches 274 and 276 may enable RF signals to bypass the internal power amplifier 204. The switch 278 may enable RF signals to bypass an off-chip power amplifier (not shown in FIG. 2A). The switch 280 may enable, for example, selection of different voltage levels for the balun 252. Different voltage levels for the balun 252 may be used, for example, for different power output levels.

The capacitors 258 and 260 may be configured by the switches 270 and 272, respectively, as additional capacitive loads to be used as needed. For example, when the LNA 202 is turned off, the switches 270 and 272 may be closed to provide various compensating capacitive loads for the power amplifier 204. The switches 270 and 272 may be controlled similarly to the switches 266 and 268 by, for example, the processor 106, the baseband processor 104, and/or the logic block 110. In one embodiment of the invention, the switches 266 and 268 may be coupled to, for example, receiver circuitry ground plane used by the LNA 202, and the switches 270 and 272 may be coupled to, for example, power amplifier ground plane used by the power amplifier 204. The invention need not be so limited, however. Various embodiments of the invention may use other ground planes.

Various parts of the device package 250, such as, for example, the capacitors 254, 256, 258, 260, 262, and/or 264, and the switches 266, 268, 270, 272, 274, 276, 278, and/or 280 may also be optimized to tolerate the various output power levels generated by the power amplifier 204. Accordingly, the capacitors 254, 256, 258, 260, 262, and/or 264, and/or the switches 266, 268, 270, 272, 274, 276, 278, and/or 280 may be able to tolerate, for example, power levels of up to 12 dBm or more if the power amplifier 204 is able to generate output power levels of 12 dBm or more. An embodiment of the invention may comprise a capacitor that may be fabricated using, for example, three layers of the device package 250. For example, portions of the layers 160a and 160c may comprise conductive electrodes, and a portion of the layer 160b may form the dielectric portion of a capacitor. Accordingly, the capacitors 254, 256, 258, 260, 262, and/or 264 may be fabricated to avoid damage at power levels of, for example, up to 12 dBm. The switches 266, 268, 270, 272, 274, 276, 278, and/or 280 may be similar to, for example, the MEMS switch 180.

Additionally, while the switches 266, 268, 270, 272, 274, 276, 278, and/or 280 may be shown as single-pole single-throw switches, the invention need not be so limited. For example, each of the switch pairs 266 and 268, 270 and 272, and/or 274 and 276 may comprise a double-pole single-throw switch.

In operation, a center tap for side B of the balun 252 may be connected to an appropriate voltage for the output power desired via, for example, switch 280. The switch 280 may enable selection among two or more voltage levels. The different voltages may be communicated to the switch 280 via, for example, the chip I/O pads 200a1 and 200a2. Accordingly, the voltage at the chip I/O pad 200a1 or the 200a2 may be communicated to the balun 252 via the transceiver 200, or directly to the device package 250 via, for example, the layer 160e.

The chip I/O pad 200a1 may be connected to a voltage V_{TF} that may be, for example, 1.5 volts for some power output levels. For example, power output levels of up to 5 dBm may use the voltage V_{TF} of 1.5 volts. Higher power output levels may use the voltage V_{TF} that may be, for example, 2.5 volts or 3.3 volts, via the chip I/O pad 200a2. Accordingly, the wireless system 100 may vary transmission power on the fly by configuring the voltage V_{TF} as needed for desired transmission power.

Additionally, while only two chip I/O pads may have been shown for input of voltage to the balun 252, the invention need not be so limited. There may be, for example, one or more voltages that may be used for the voltage V_{TF}.

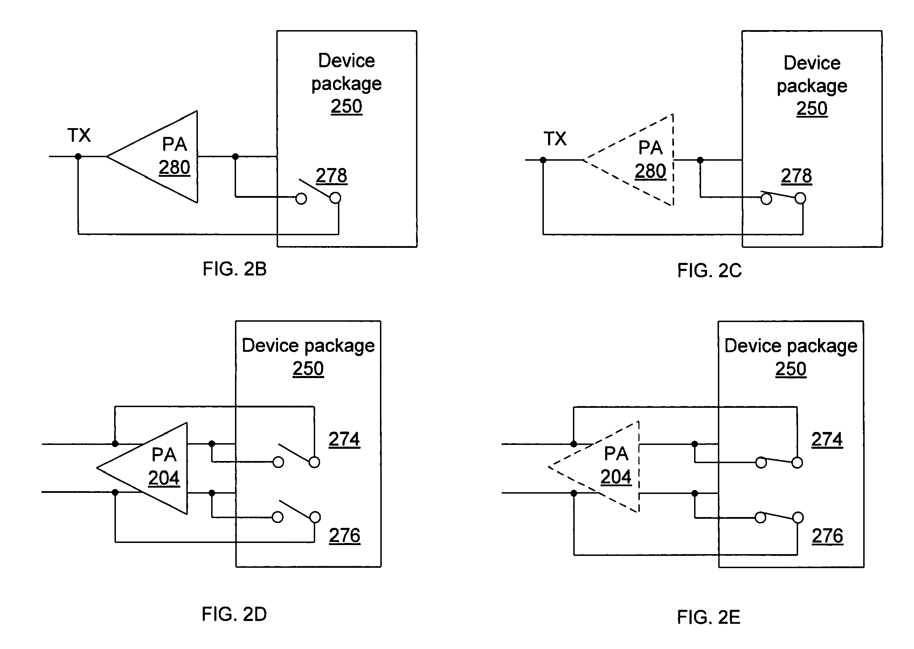

The switches 266 and 268 may be opened or closed depending on whether an off-chip power amplifier (not shown for FIG. 2) is used, whether the transceiver 200 may be operating in a receive mode or a transmit mode, and whether differential mode may be used.

For example, a transmit mode that may utilize an off-chip power amplifier may use one of the chip I/O pads 200b and 200c to input received RF signals to the transceiver 200 and may use the other of the chip I/O pads 200b and 200c to output RF signals to be amplified by an off-chip power amplifier. Accordingly, the input and output RF signals at the chip interface may be single-ended via the chip I/O pads 200b and 200c. For another transmit mode that may not use an off-chip power amplifier, the power amplifier 204 may be used to output power of up to, for example, 5 dBm, or substantially 5 dBm. The transceiver 200 may be configured for use with higher output power, such as, for example, substantially 12 dBm. The output of the transceiver 200 at the chip interface may also be a single-ended output via the chip I/O pads 200b and 200c. The transceiver 200 may also be configured for differential input/output via the chip I/O pads 200b and 200c.

The received RF signals may be communicated from, for example, an antenna such as the antenna 101. While the antenna 101 may have been described as a single antenna, the invention need not be so limited. For example, the antenna 101 may comprise a plurality of antennas, and there may be separate antennas dedicated to transmission and to reception.

The exemplary upper power limits discussed, substantially 5 dBm and 12 dBm, may change with different embodiments of the RF front end in the transceiver 200. For example, other embodiments of the invention may allow upper power limits of substantially 7 dBm and 15 dBm, or other power levels.

FIG. 2B is an exemplary block diagram that illustrates using an off-chip power amplifier, in accordance with an embodiment of the invention. Referring to FIG. 2B, there is shown the device package 250 and the off-chip power amplifier 280. The wireless system 100 may, for example, be configured to use the off-chip power amplifier 280 by leaving the switch 278 in an open state. Accordingly, the input of the off-chip power amplifier 280 may not be short-circuited to the output of the off-chip power amplifier 280. This may allow RF signals to be amplified by the off-chip power amplifier 280, regardless of whether the RF signals have already been amplified by the on-chip power amplifier 204. This may be utilized in, for example, applications that require additional power.

FIG. 2C is an exemplary block diagram that illustrates bypassing an off-chip power amplifier, in accordance with an embodiment of the invention. Referring to FIG. 2C, there is shown the device package 250 and the off-chip power amplifier 280. The wireless system 100 may, for example, be configured to bypass the off-chip power amplifier 280 by closing the switch 278. Accordingly, the input of the off-chip power amplifier 280 may be short-circuited to the output of the off-chip power amplifier 280. The off-chip power amplifier 280 may also be shut off, for example, to prevent damage to the off-chip power amplifier 280 by connecting the output directly to the input.

Additionally, depending on a specific configuration used, the wireless system 100 may use the off-chip power amplifier 280 to further amplify RF signals already amplified, for example, by the on-chip power amplifier 204. Furthermore, if the off-chip power amplifier 280 is not present, and there is no connection from the input trace and the output trace for the off-chip power amplifier 280, the switch 278 may be closed to enable transmission of the RF signals amplified by, for example, the on-chip power amplifier 204.

FIG. 2D is an exemplary block diagram that illustrates using an on-chip power amplifier, in accordance with an embodiment of the invention. Referring to FIG. 2D, there is shown the device package 250 and the on-chip power amplifier 280. The wireless system 100 may, for example, be configured to use the on-chip power amplifier 204 by leaving open the switches 274 and 276. Accordingly, the inputs of the on-chip power amplifier 204 may not be short-circuited to the outputs of the on-chip power amplifier 204. Depending on the specific configuration used, the wireless system 100 may apply further amplification to the RF signals by using, for example, the off-chip power amplifier 280. In this instance, the switch 278 may be left open.

However, in instances where further amplification of the RF signals may not be desired, the switch 278 may be closed. Additionally, if the off-chip power amplifier 280 is not present, and there is no connection from the input trace and the output trace for the off-chip power amplifier 280, the switch 278 may be closed to enable transmission of the RF signals via, for example, the antenna 101.

FIG. 2E is an exemplary block diagram that illustrates bypassing an on-chip power amplifier, in accordance with an embodiment of the invention. Referring to FIG. 2E, there is shown the device package 250 and the on-chip power amplifier 204. The wireless system 100 may, for example, be configured to bypass the on-chip power amplifier 280 by closing the switches 274 and 276. Accordingly, the input of the on-chip power amplifier 204 may be short-circuited to the output of the on-chip power amplifier 204. The on-chip power amplifier 204 may also be shut off, for example, to prevent damage to the on-chip power amplifier 204 by connecting the output directly to the input. Since, the on-chip power amplifier may be bypassed, various embodiments of the invention may use an off-chip power amplifier such as, for example, the off-chip power amplifier 280. Accordingly, the switch 278 may be left open to enable RF signals to be amplified by the off-chip power amplifier 280.

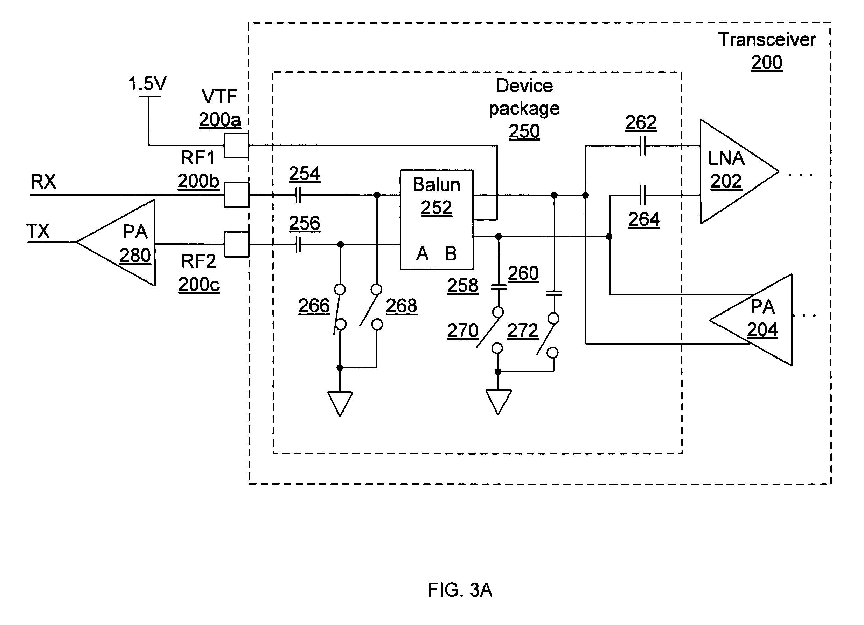

FIG. 3A is a block diagram illustrating an exemplary configuration of a transceiver on a chip, in accordance with an embodiment of the invention. Referring to FIG. 3A, there is shown the transceiver 200 and the device package 250 in an exemplary configuration for a receive operation. There are also shown I/O pads 200a, 200b, and 200c for input and output of signals. The I/O pads may be part of the transceiver 200, or the I/O pads may be part of the device package 250. Only a single I/O pad 200a is shown for the voltage V_{TF} for exemplary purposes.

The transceiver 200 and the device package 250 may be configured for use with an off-chip power amplifier 280. Accordingly, the switch 278 (not shown) may be in an open position as described with respect to FIG. 2B. Additionally, the on-chip power amplifier 204 may be used, as described with respect to FIG. 2D, or bypassed as described with respect to FIG. 2E.

The voltage V_{TF} may be, for example, 1.5 volts and the LNA 202 may be turned on. The switch 266 may be closed and the switch 268 may be open. In this manner, the input to the off-chip power amplifier 280 may be grounded, while the received RF signals may be communicated to the transceiver 200. Additionally, during the receive mode, the inputs to the power amplifier 204 may be at a very low power level, if not ground level. Accordingly, the power amplifier 204 may generate very little, if any, RF signals that may interfere with the operation of the LNA 202. Other embodiments of the invention may comprise a power amplifier 204 that may be turned off.

The received RF signals may be communicated to side A of the balun 252 via, for example, the I/O pad 200b. The differential RF output signals from side B of the balun 252 may be communicated to the LNA 202. The LNA 202 may be turned on to amplify the received RF signals. The output of the LNA 202 may be further amplified, filtered, downconverted, and/or demodulated to a baseband signal. The baseband signal may then be communicated to the baseband processor 104 for further processing.

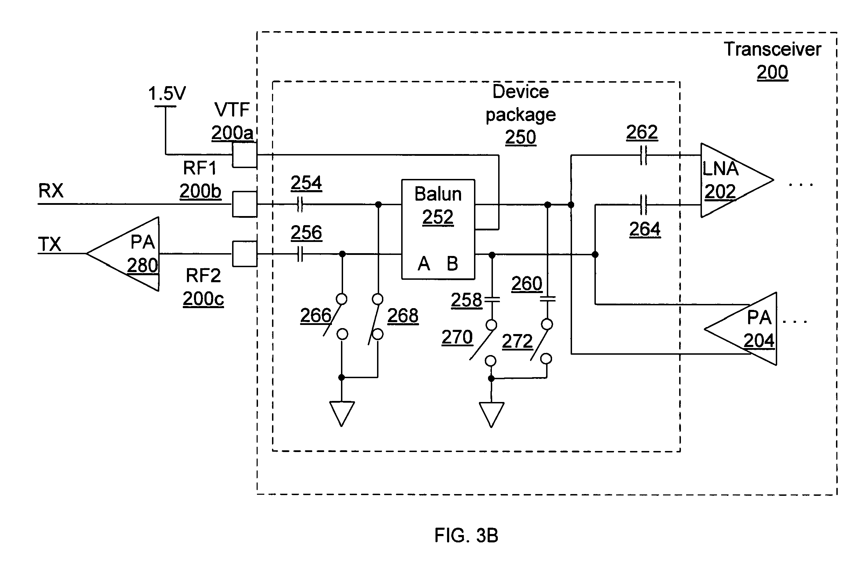

FIG. 3B is a block diagram illustrating an exemplary configuration of a transceiver on a chip, in accordance with an embodiment of the invention. Referring to FIG. 3A, there is shown the transceiver 200 and the device package 250 in an exemplary configuration for a transmit operation. There are also shown I/O pads 200a, 200b, and 200c for input and output of signals. The I/O pads may be part of the transceiver 200, or the I/O pads may be part of the device package 250. Only a single I/O pad 200a is shown for the voltage V_{TF} for exemplary purposes.

The transceiver 200 and the device package 250 may be configured for use with an off-chip power amplifier 280. Accordingly, the switch 278 (not shown) may be in an open position as described with respect to FIG. 2B. Additionally, the on-chip power amplifier 204 may be used, as described with respect to FIG. 2D, or bypassed as described with respect to FIG. 2E.

The transceiver 200 and the device package 250 may be configured for use with the off-chip power amplifier 280. The voltage V_{TF} may be, for example, 1.5 volts for transmit power of up to, for example, substantially 5 dBm. The output power level of the transceiver 200 may depend, for example, on input and amplifying specifications of the off-chip power amplifier 280. The LNA 202 may be turned off since the transceiver 200 may be in a transmit mode. The switch 266 may be open and the switch 268 may be closed. In this manner, the input to the off-chip power amplifier 280 may be from the output of side A of the balun 252. The received RF signals may be, for example, shorted to ground via the closed switch 204.

During the transmit mode, RF signals to be transmitted may be communicated to the inputs of the on-chip power amplifier 204. Depending on whether the on-chip power amplifier 204 is used, the switches 274 and 276 may be configured as described with respect to FIGs. 2D and 2E. Accordingly, the RF signals at the outputs of the on-chip power amplifier 204 may be communicated to the B side of the balun 252. The RF signals may then be coupled to the A side of the balun 252, and thus communicated to the off-chip power amplifier 280 via the I/O pad 200c. The output of the off-chip power amplifier 280 may be communicated to an antenna, for example, the antenna 101, for transmission.

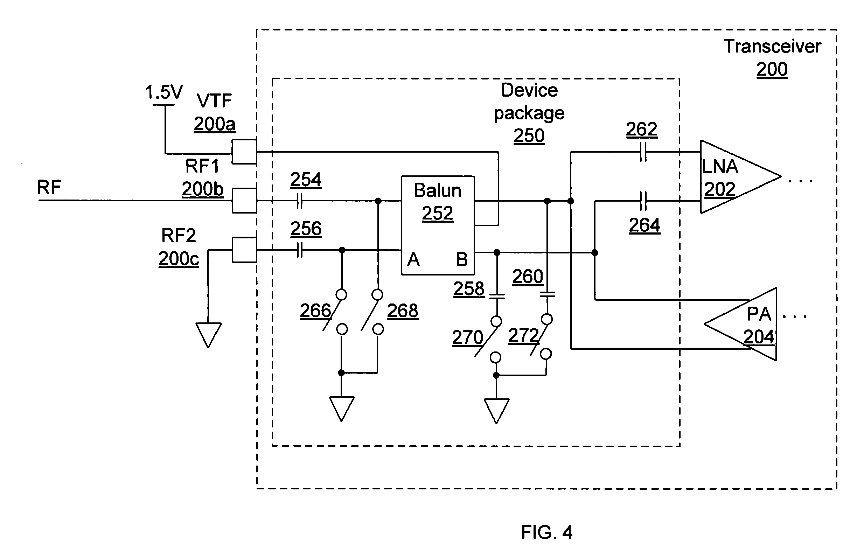

FIG. 4 is a block diagram illustrating an exemplary configuration of a transceiver on a chip, in accordance with an embodiment of the invention. Referring to FIG. 4, there is shown the transceiver 200 and the device package 250 in an exemplary configuration for transmit and receive operations. There are also shown I/O pads 200a, 200b, and 200c for input and output of signals. The I/O pads may be part of the transceiver 200, or the I/O pads may be part of the device package 250. Only a single I/O pad 200a is shown for the voltage V_{TF} for exemplary purposes.

The transceiver 200 and the device package 250 may be configured for use without an off-chip power amplifier 280. Accordingly, the switch 278 (not shown) may be controlled as described with respect to FIG. 2C, and the switches 274 and 276 may be controlled as described with respect to FIG. 2D.

In the transmit mode, the output power of the transceiver 200 may be up to, for example, substantially 5 dBm. Accordingly, the voltage V_{TF} may be, for example, 1.5 volts. The LNA 202 may be turned off for single-ended transmit operation. The I/O pad 200b may be used, for example, to communicate RF signals to the antenna 101 for transmission. The I/O pad 200c may be, for example, coupled to ground.

The switches 266 and 268 may be open. In this manner, the RF signals to be transmitted may be communicated to the inputs of the power amplifier 204 where the RF signals may be amplified. The amplified RF signals may then be communicated to the B side of the balun 252. The RF signals may be coupled to the A side of the balun 252, and thus communicated to the I/O pad 200b. The RF signals may then be communicated to the antenna 101 for transmission.

In the receive mode, the RF signals may be received by the antennal 101 and the received RF signals may be communicated to the A side of the balun 252 via the I/O pad 200b. The RF signals may be coupled to the LNA 202 via the B side of the balun 252. The inputs to the power amplifier 204 may be at a very low power level, if not ground level. Accordingly, the power amplifier 204 may generate very little, if any, RF signals that may interfere with the operation of the LNA 202. Other embodiments of the invention may comprise a power amplifier 204 that may be turned off.

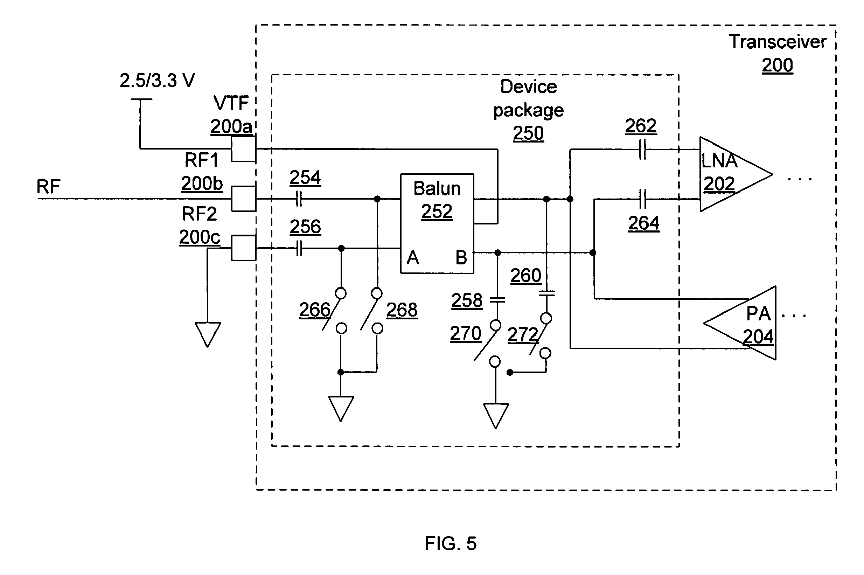

FIG. 5 is a block diagram illustrating an exemplary configuration of a transceiver on a chip, in accordance with an embodiment of the invention. Referring to FIG. 5, there is shown the transceiver 200 and the device package 250 in an exemplary configuration for transmit and receive operations that may not use an off-chip power amplifier. There are also shown I/O pads 200a, 200b, and 200c for input and output of signals. The I/O pads may be part of the transceiver 200, or the I/O pads may be part of the device package 250. Only a single I/O pad 200a is shown for the voltage V_{TF} for exemplary purposes.

The transceiver 200 and the device package 250 may be configured for use without an off-chip power amplifier 280. Accordingly, the switch 278 (not shown) may be controlled as described with respect to FIG. 2C, and the switches 274 and 276 may be controlled as described with respect to FIG. 2D.

In the transmit mode, the output power of the transceiver 200 may be up to, for example, substantially 12 dBm. Accordingly, the voltage V_{TF} may be, for example, 2.5 volts or 3.3 volts for the higher power output from the power amplifier 204. The LNA 202 may be turned off for single-ended transmit operation. The I/O pad 200b may be used, for example, to communicate RF signals to the antenna 101 for transmission, and the I/O pad 200c may be, for example, coupled to ground.

The switches 266 and 268 may be open. In this manner, the RF signals to be transmitted may be communicated to the inputs of the power amplifier 204 where the RF signals may be amplified. The amplified RF signals may then be communicated to the B side of the balun 252. The RF signals may be coupled to the A side of the balun 252, and thus communicated to the I/O pad 200b. The RF signals may then be communicated to the antenna 101 for transmission. The LNA 202 may be designed to be protected from high output power, for example, of up to substantially 12 dBm at its input nodes.

In the receive mode, the RF signals may be received by the antennal 101 and the received RF signals may be communicated to the A side of the balun 252 via the I/O pad 200b. The RF signals may be coupled to the LNA 202 via the B side of the balun 252. The inputs to the power amplifier 204 may be at a very low power level, if not ground level. Accordingly, the power amplifier 204 may generate very little, if any, RF signals that may interfere with the operation of the LNA 202. Other embodiments of the invention may comprise a power amplifier 204 that may be turned off.

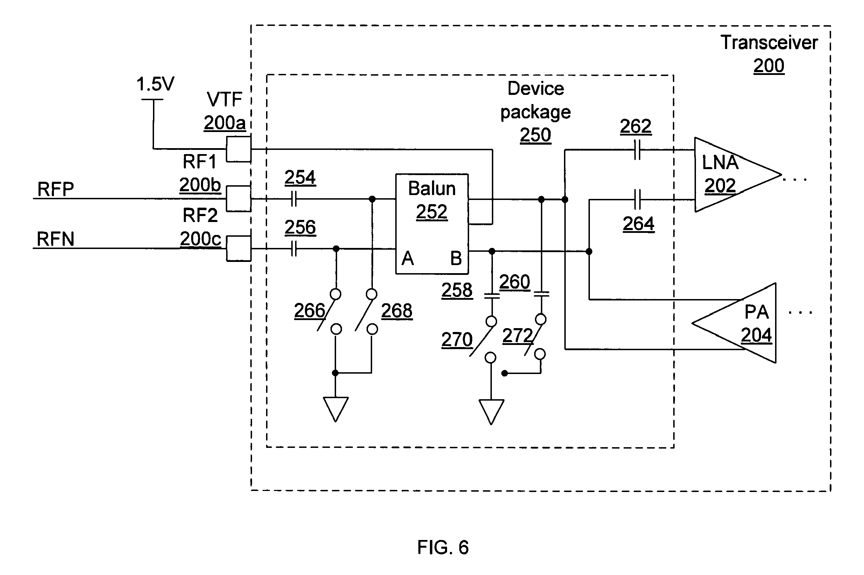

FIG. 6 is a block diagram illustrating an exemplary configuration of a transceiver on a chip, in accordance with an embodiment of the invention. Referring to FIG. 6, there is shown the transceiver 200 and the device package 250 in an exemplary configuration for differential transmission and reception. There are also shown I/O pads 200a, 200b, and 200c for input and output of signals. The I/O pads may be part of the transceiver 200, or the I/O pads may be part of the device package 250. Only a single I/O pad 200a is shown for the voltage V_{TF} for exemplary purposes.

The transceiver 200 and the device package 250 may be configured for use without an off-chip power amplifier 280. Accordingly, the switch 278 (not shown) may be controlled as described with respect to FIG. 2C, and the switches 274 and 276 may be controlled as described with respect to FIG. 2D.

The voltage V_{TF} may be, for example, 1.5 volts. The switches 266 and 268 may be open. The LNA 202 may be turned off for transmit operations. The I/O pads 200b and 200c may be used to communicate differential RF signals externally to the chip with the transceiver 200. External circuitry (not shown) may be used to process the differential signals from the transceiver 200.

In this manner, the RF signals to be transmitted may be communicated to the inputs of the power amplifier 204 where the RF signals may be amplified. The amplified RF signals may then be communicated to the B side of the balun 252. The RF signals may be coupled to the A side of the balun 252, and thus communicated to the I/O pad 200b. The RF signals may then be communicated to the antenna 101 for transmission. The LNA 202 may be designed to be protected from high output power of up to, for example, substantially 12 dBm at its input nodes.

For receive operations, the LNA 202 may be turned on to amplify received RF signals. The I/O pads 200b and 200c may be used to receive differential RF signals to the transceiver 200. External circuitry (not shown) may be used to generate the differential RF signals from the RF signals received by the antenna 101. The differential RF signals may be communicated to the A side of the balun 252, and the differential RF signals may be coupled to the B side of the balun 252. The differential RF signals may then be communicated to the LNA 202.

Additionally, during the receive mode, the inputs to the power amplifier 204 may be at a very low power level, if not ground. Accordingly, the power amplifier 204 may generate very little, if any, RF signals that may interfere with the operation of the LNA 202. Other embodiments of the invention may comprise a power amplifier 204 that may be turned off.

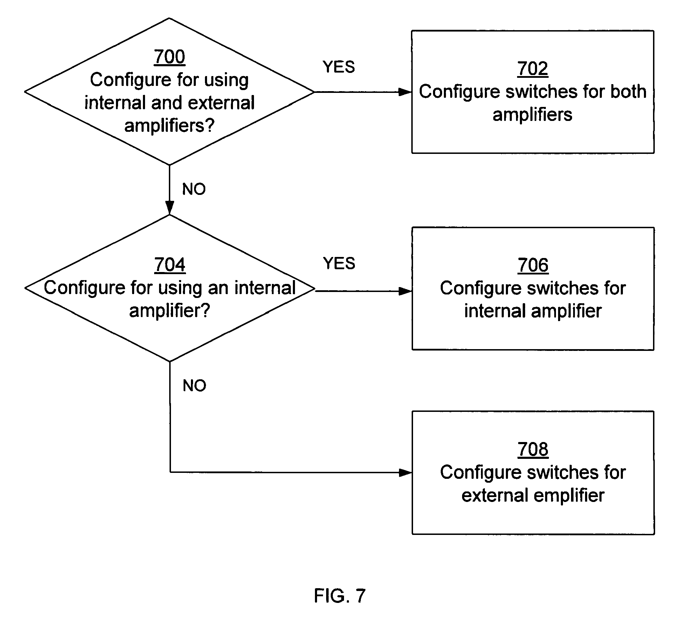

FIG. 7 is a flow diagram illustrating exemplary steps for using a flip-chip RF front end with switchable power amplifier, in accordance with an embodiment of the invention. Referring to FIG. 7, there is shown steps 700 to 708. In step 700, a determination may be made as to whether the transceiver 200 may use both the internal amplifier 204 and the external amplifier 280. If the transceiver 200 is to use both the internal amplifier 204 and the external amplifier 280, the next step may be step 702. If the transceiver 200 is to operate with just the internal amplifier 204 or the external amplifier 280, the next step may be step 704.

In step 702, various devices in the balun package 170, such as, for example, the switches 274, 276, and 278 may be configured appropriately for using both the internal amplifier 204 and the external amplifier 280. For example, the switches 274, 276, and 278 may be configured to be open.

In step 704, a determination may be made as to whether the transceiver 200 may use the internal amplifier 204 or the external amplifier 280. If the transceiver 200 is to use the internal amplifier 204, the next step may be step 706. If the transceiver 200 is to use the external amplifier 280, the next step may be step 708.

In step 706, various devices in the balun package 170, such as, for example, the switches 274, 276, and 278 may be configured appropriately for using only the internal amplifier 204. Accordingly, the switches 274 and 276 may be open, and the switch 278 may be closed. In step 708, the switches 274, 276, and 278 may be configured appropriately using only the external amplifier 280. Accordingly, the switches 274 and 276 may be closed, and the switch 278 may be open.

In accordance with an embodiment of the invention, aspects of an exemplary system may comprise controlling switches 172 on the device package 170. The device package 170 may comprise one or more layers. Various embodiments of the invention may comprise fabricating the device package 170 with magnetic material in one or more of the layers. The switches 172 may be fabricated using MEMS technology, and/or MEMS switches 172 may be mounted on a surface of the device package 170. Accordingly, the switches 172 may be similar to, for example, the MEMS switch 180. The switches 172 may comprise, for example, the switches 266, 268, 270, 272, 274, 276, 278, and/or 280. The switches 172 may be controlled, for example, by the baseband processor 104, the processor 106, and/or the logic block 110. Accordingly, the switches 172 may be controlled to bypass the RF power amplifiers 204 and/or 280. If a power amplifier is present, and it is not bypassed, that power amplifier may be used to amplify RF signals.

For example, the wireless system 100 may comprise at least two power amplifiers 204 and 280. The power amplifier 204 may be an on-chip power amplifier that may be part of the flip-chip integrated circuit 150. The power amplifier 280 may be an off-chip power amplifier that may not be part of the flip-chip integrated circuit 150 nor part of the device package 170. The switches 274 and 276 may be used to bypass the on-chip power amplifier 204, and the switch 278 may be used to bypass the off-chip power amplifier 280.

Accordingly, by appropriate control of the switches 274, 276, and 278, the on-chip power amplifier 204 may be used to amplify RF signals while the off-chip power amplifier 280 may be bypassed. The switches 274, 276, and 278 may also be controlled to bypass the on-chip power amplifier 204 while using the off-chip power amplifier 280 to amplify RF signals. The switches 274, 276, and 278 may also be used to enable both the on-chip RF power amplifier 204 and the off-chip RF power amplifier 280 to amplify RF signals.

Various devices on the flip-chip bonded integrated circuit 150 and/or the device package 170 may be configured for receiving and/or transmitting RF signals. The flip-chip bonded integrated circuit 150 and/or the device package 170 may be configured for single-ended RF input, single-ended RF output, differential RF input, and/or differential RF output.

Some of the various configurations that may be utilized for various embodiments of the invention have been described with respect to FIGs. 3A-6, however the invention need not be limited to these particular configurations.

Another embodiment of the invention may provide a machine-readable storage, having stored thereon, a computer program having at least one code section executable by a machine, thereby causing the machine to perform the steps as described above for a flip-chip RF front end with switchable power amplifier.

Accordingly, the present invention may be realized in hardware, software, or a combination of hardware and software. The present invention may be realized in a centralized fashion in at least one computer system, or in a distributed fashion where different elements are spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will comprise all embodiments falling within the scope of the appended claims.

## Claims

1. A method for processing signals, the method comprising:
controlling at least one switch on a device package, wherein said at least one switch enables RF signals to bypass one or more of a plurality of RF power amplifiers and/or be amplified by others of said plurality of power amplifiers, and wherein said device package is mounted above a flip-chip bonded integrated circuit.

2. The method according to claim 1, wherein said at least one switch is fabricated on said device package using micro electro-mechanical system (MEMS) technology.

3. The method according to claim 1, comprising amplifying said RF signals via an on-chip RF power amplifier that is part of said flip-chip bonded integrated circuit.

4. The method according to claim 3, comprising, if there is an off-chip RF power amplifier, enabling said RF signals to bypass said off-chip power amplifier.

5. The method according to claim 1, comprising amplifying said RF signals via an off-chip RF power amplifier.

6. The method according to claim 5, comprising enabling said RF signals to bypass an on-chip RF power amplifier that is part of said flip-chip bonded integrated circuit.

7. A system for processing signals, the system comprising:
one or more circuits that enable controlling of at least one switch on a device package, wherein said at least one switch enables RF signals to bypass one or more of a plurality of RF power amplifiers and/or be amplified by others of said plurality of power amplifiers, and wherein said device package is mounted above a flip-chip bonded integrated circuit.

8. The system according to claim 7, wherein said at least one switch is fabricated on said device package using micro electro-mechanical system (MEMS) technology.

9. The system according to claim 7, wherein said plurality of RF power amplifiers comprise an on-chip RF power amplifier that enables amplification of said RF signals.

10. The system according to claim 9, wherein said on-chip RF power amplifier is part of said flip-chip bonded integrated circuit.
